# EUROPÄISCHE PATENTSCHRIFT

(11) **EP 2 904 676 B1**
(45) Veröffentlichungstag und Bekanntmachung des Hinweises auf die Patenterteilung: **31.01.2018**
(21) Anmeldenummer: 13753175.2
(22) Anmeldetag: 23.08.2013
(51) Int. Cl.: H02H 5/04, H02H 7/22, G01K 13/00, G01R 31/02

(54) **VERFAHREN ZUM ÜBERWACHEN MEHRERER ELEKTRISCHER ENERGIELEITUNGEN EINES LEITUNGSSTRANGS**
METHOD FOR MONITORING A PLURALITY OF ELECTRICAL ENERGY LINES IN A CABLE HARNESS
PROCÉDÉ POUR SURVEILLER PLUSIEURS LIGNES ÉLECTRIQUES D'UN FAISCEAU DE LIGNES

(30) Priorität: 02.10.2012 DE 102012218067
(43) Veröffentlichungstag der Anmeldung: 12.08.2015
(73) Patentinhaber: Wobben Properties GmbH, 26607 Aurich (DE)
(72) Erfinder: DE BOER, Joachim, 26605 Aurich (DE)
(74) Vertreter: Eisenführ Speiser
(86) Internationale Anmeldenummer: PCT/EP2013/067588
(87) Internationale Veröffentlichungsnummer: WO 2014/053273

(56) Entgegenhaltungen:
- WO-A1-2004/107550
- DE-A1-102005 022 060
- DE-A1-102009 021 217
- JP-A- H07 193 986

## Beschreibung

Die vorliegende Erfindung betrifft ein Verfahren zum Überwachen eines mehrere elektrische Leitungen, insbesondere elektrische Energieleitungen, umfassenden Leitungsstrangs. Weiterhin betrifft die vorliegende Erfindung eine Überwachungsvorrichtung zum Überwachen eines mehrere elektrische Leitungen umfassenden Leitungsstrangs, und die vorliegende Erfindung betrifft eine Windenergieanlage.

Es ist bekannt, elektrische Energie von einem elektrischen Generator einer Windenergieanlage über elektrische Leitungen in einem Turm der Windenergieanlage hinunterzuführen zum Turmfuß, um dort diese elektrische Energie weiterzuleiten und/oder weiterzuverarbeiten. Bei einem bekannten Beispiel erzeugt der Generator einen Wechselstrom, beispielsweise in Form von zwei dreiphasigen Wechselströmen. Diese Wechselströme werden in der Gondel, in dem der Generator angeordnet ist, gleichgerichtet und der dabei erzeugte Gleichstrom über Gleichstromleitungen von der Gondel und damit etwa vom Turmkopf den Turm hinunter zum Turmfuß geleitet. Hierzu werden häufig mehrere gleichartige Leitungen parallel geschaltet, um eine zu dicke und damit schwer handhabbare Leitung zu vermeiden und den notwendigen Gesamtleitungsquerschnitt durch die Verwendung mehrerer parallel geschalteter Leitungen zu realisieren. Diese Leitungen können beispielsweise im Turmkopf und Turmfuß jeweils über eine Klemmschiene elektrisch leitend verbunden sein. Beispielsweise können dadurch 16 Leitungen parallel geschaltet sein, indem sie an dieser Schiene elektrisch, also galvanisch miteinander verbunden sind. Der erzeugte Gleichstrom wird dann auf diese Schiene oder ähnliches Bauteil gegeben und verteilt sich idealerweise gleichmäßig auf die einzelnen Leitungen. Die gleichmäßige Verteilung des Stroms auf die elektrischen Leitungen ergibt sich dabei im Grunde physikalisch bedingt. Haben sämtliche Leitungen insbesondere gleichen Querschnitt und gleiche Länge, nämlich etwa Turmlänge, weisen sie auch einen gleichen ohmschen Widerstand bzw. allgemein gesprochen eine gleiche Impedanz auf. Entsprechend stellt sich in jeder Leitung derselbe Strom ein.

In der Realität kann es jedoch vorkommen, dass Defekte vorliegen oder zumindest unakzeptable Ungenauigkeiten vorliegen. So können beispielsweise vereinzelt hohe Übergangswiderstände, Unterbrechungen, Kurzschlüsse oder Ähnliches vorliegen, was eventuell zu einem überhöhten Strom in jedenfalls einem der Leiter führen kann. Fehlerhaft oder ungenügend angeschlossene einzelne Leitungen können dazu führen, dass durch sie weniger oder im extremsten Fall gar kein Strom fließt und die übrigen Leitungen entsprechend mehr Strom aufnehmen und führen müssen.

Das Deutsche Patent- und Markenamt hat in der Prioritätsanmeldung zu vorliegender Anmeldung folgenden Stand der Technik recherchiert: DE 10 2009 021 217 A1 und EP 2 270 452 A2. In DE 10 2009 021 217 A1 wird ein Schienenverteilersystem mit einer Vielzahl von miteinander verbundenen Stromschienenstücken beschrieben. Das Schienenverteilersystem ist mit mehreren Abgangskästen und/oder elektrischen Geräten verbunden. Die Temperaturen der Schienenverteilersysteme werden über Temperatursensoren überwacht.

Ferner ist aus Dokument WO 2004/107550 A1 bekannt, Temperaturen einzelner Phasen von Umrichtern zu messen, um ein Alarmsignal bereitzustellen, sodass Defekte der einzelnen Phasen des Umrichters detektierbar sind. Außerdem offenbart JP H07 193986 A, dass die Temperatur von drei Phasen eines Leitungsstrangs jeweils am gleichen Punkt gemessen wird.

Der vorliegenden Erfindung liegt somit die Aufgabe zugrunde, zumindest eines der oben genannten Probleme zu adressieren. Insbesondere soll eine vereinfachte Lösung geschaffen werden, die ordnungsgemäße Funktion mehrerer parallel geschalteter Leitungen zum Führen eines Stroms von einem Generator einen Turm hinunter zu überprüfen. Insbesondere soll möglichst auch der apparative Aufwand gering gehalten werden, und vorzugsweise soll eine Störanfälligkeit ebenfalls möglichst gering gehalten werden. Zumindest soll eine alternative Lösung vorgeschlagen werden.

Erfindungsgemäß wird ein Verfahren nach Anspruch 1 vorgeschlagen. Dieses Verfahren überwacht einen Leitungsstrang mit mehreren elektrischen Leitungen, wobei der Leitungsstrang zum Leiten elektrischer, von einem Generator einer Windenergieanlage erzeugter Energie vorbereitet ist. Der Leitungsstrang führt somit einen entsprechenden Strom und dadurch die erzeugte Energie des Generators. Der Strom kann dabei für eine Weiterverarbeitung, insbesondere eine Gleichrichtung eines vom Generator erzeugten Stroms erzeugt worden sein.

Weiterhin wird an wenigstens zwei der elektrischen Leitungen jeweils eine Temperatur gemessen. Es stehen somit wenigstens zwei Leitungstemperaturen zur Verfügung, und diese gemessenen Temperaturen werden untereinander verglichen, insbesondere jede gemessene Temperatur mit jeder anderen gemessenen Temperatur. Bei bzw. durch Auswertung dieses Vergleichs der jeweiligen Temperaturen untereinander wird erfasst, ob zwei Temperaturen um mehr als eine vorbestimmte Grenze voneinander abweichen. Es kommt somit auf das Verhältnis der Temperaturen zueinander an. Natürlich können auch die absoluten Temperaturen berücksichtigt werden, um beispielsweise eine absolute Überlastung der Leitungen zu erkennen, der erfindungsgemäße Vorschlag beruht aber auf dem Vergleich zweier Temperaturen.

Dem liegt die Überlegung zugrunde, dass die Leitungen im Normalfall elektrisch gleich belastet sind, insbesondere dass gleiche Leitungen gleich viel Strom führen. Tritt nun eine Störung auf, bei der beispielsweise eine der Leitungen schlecht kontaktiert oder beispielsweise beschädigt ist, so kann diese Leitung einen höheren Gesamtwiderstand aufweisen und entsprechend weniger Strom führen. Die übrigen Leitungen, insbesondere die wenigstens eine weitere überwachte Leitung führt dann entsprechend mehr Strom. Im Ergebnis führen diese unterschiedlichen Ströme zu einer unterschiedlichen Erwärmung der beiden Leitungen und damit zu unterschiedlichen Temperaturen und schließlich zu einer über einer vorbestimmten Grenze liegenden Abweichung der verglichenen Temperaturen zueinander.

Die Temperaturen in der Leitung werden durch diverse weitere Einflüsse beeinflusst, wie die Höhe des Gesamtstroms, der bei der Windenergieanlage nicht zuletzt auch von den vorherrschenden Windbedingungen abhängt. Außerdem können auch entsprechende Umgebungstemperaturen im Turm bzw. an dem Aufstellungsort des Turmes die Temperatur der Leitungen beeinflussen. Diese mehr oder weniger externen Temperatureinflüsse wirken aber auf die Leitungen des Strangs gleichermaßen oder zumindest im Wesentlichen gleichermaßen. Durch die Erfassung der Temperaturdifferenzen kann daher die Auswertung weiterer Randbedingungen außer Acht bleiben.

Außerdem führt jedenfalls die beispielhaft beschriebene Verringerung des Stroms in einer Leitung, verbunden mit einer Erhöhung des Stroms in einer anderen Leitung zu einer vergleichsweise großen Temperaturdifferenz und damit zu einem gut geeigneten Indikator für ein Problem in diesem Leitungsstrang.

Die vorbestimmte Grenze, die auch als Grenzdifferenztemperatur bezeichnet werden kann, kann aus Erfahrungswerten oder Vorabmessungen vor Inbetriebnahme fest vorgegeben werden. Ebenso kommt in Betracht, die Temperaturen zumindest in einer ersten Testanlage an den jeweiligen Leitungen zu messen und zu erfassen und daran normale Abweichungen der Temperaturen zueinander aufzunehmen. Vorzugsweise wird somit diese Grenze bzw. Grenztemperaturdifferenz auf einen Wert festgesetzt, der die so erfassten normalen Abweichungen überschreitet. Wird die Temperatur an drei oder mehr Leitungen erfasst, kann vorteilhafterweise vorgesehen werden, unterschiedliche Grenzen bzw. Grenzdifferenztemperaturen vorzugeben, nämlich abhängig davon, welche Leitung mit welcher verglichen wird. Solche unterschiedlichen Grenzen können entsprechend auch durch die beschriebene Vorabmessung und Voraberfassung normaler Abweichungen, insbesondere normaler Schwankungen, bestimmt werden.

Die vorgegebene Grenze kann auch vorab festgelegt werden und anschließend im Betrieb der Anlage, abhängig von vorgenommenen Messungen, angepasst werden.

Vorzugsweise wird ein Warnsignal, das auch als eine Störmeldung angesehen werden kann, ausgegeben, wenn erfasst wurde, dass zwei Temperaturen um mehr als die vorbestimmte Grenze voneinander abweichen. Ein solches Warnsignal kann als internes Signal an einen Prozessrechner oder dergleichen übergeben werden, der weitere Maßnahmen einleiten kann, insbesondere eine Drosselung der Windenergieanlage, notfalls ein Abschalten der Windenergieanlage, aber auch alternativ oder zusätzlich das Versenden eines Warnsignals, wie beispielsweise an eine Leitzentrale über Scada.

Vorzugsweise ist der zu überwachende Leitungsstrang im Turm der Windenergieanlage verlegt, und die gesamte vom Generator erzeugte Energie - abzüglich Verluste - wird den Turm hinab geführt. Somit betrifft dieses Überwachungsverfahren, nämlich insbesondere das Überwachen von Energieleitungen, die im Wesentlichen elektrische Energie übertragen. Solche Energieleitungen sind entsprechend dafür ausgelegt, einen großen Strom zu leiten, nicht nur Informationen zu übertragen. Zudem werden solche Energieleitungen zu Strängen zusammengefasst, die dazu vorgesehen sind, einen Gesamtstrom zu leiten, in dem dieser Gesamtstrom möglichst gleichmäßig auf die Leitungen dieses Strangs aufgeteilt werden. Eine Fehlfunktion wie ein fehlerhaftes Anschließen einer Leitung führt somit zu entsprechenden Verschiebungen der Stromaufteilung zwischen den Leitungen. Aufgrund der vergleichsweise hohen zu erwartenden Ströme macht sich dies thermisch bemerkbar und wird durch den vorgeschlagenen Vergleich der Temperaturen an der entsprechenden Leitung erfasst.

Vorzugsweise sind die Leitungen des Leitungsstrangs, die überwacht werden, zueinander parallel geschaltet und dazu vorbereitet, jeweils einen gleich großen Strom zu führen. Dafür sind die Leitungen im Wesentlichen gleich, nämlich vom gleichen Typ, gleicher Ausführung und/oder weisen eine gleiche Länge und/oder einen gleichen Leitungsquerschnitt auf. Die gleiche Länge dürfte üblicherweise vorliegen, da der gesamte Strang und damit jede einzelne Leitung jedenfalls vorzugsweise vom Turmkopf zum Turmfuß reicht, wobei statt eines Turmes auch ein Mast vorliegen kann. Liegt nun ein gleicher Leitungsquerschnitt vor und dabei gleiches Material wie insbesondere Kupfer oder Aluminium, sind die elektrischen Leitungen zunächst in ihrer elektrischen Leitfähigkeit gleichwertig. Hinzu kommt, wenn gleiche Ummantelungen verwendet werden, sind auch die thermischen Isolationseigenschaften gleich. Vorzugsweise werden ohnehin insgesamt gleiche Leitungen verwendet, um die Verwendung einer im Querschnitt großen Leitung zu verhindern, die - sofern sie überhaupt beschaffbar ist - schwer zu handhaben wäre.

Vorzugsweise wird die Temperatur aller zu überwachenden Leitungen in Längsrichtung des Leitungsstrangs an derselben Stelle gemessen, also insbesondere an einer Anschluss- oder Messstelle im Turmkopf oder an einer Anschluss- oder Messstelle im Turmfuß. Somit wird vermieden, dass unterschiedliche Messstellen, also insbesondere unterschiedliche Messhöhen, zu unterschiedlichen Temperaturen führen und die Aussagekräftigkeit des vorgeschlagenen Vergleichs damit schwächen. Außerdem ist auch eine vorteilhafte Verbindung der Messsensoren mit einer Auswerteeinrichtung und Weiterverwertung der Daten im Turmkopf, insbesondere in einer Gondel der Windenergieanlage, oder im Turmfuß vergleichsweise einfach realisierbar. Sämtliche Messwerte werden dann im Wesentlichen an einer Stelle aufgenommen und dort ausgewertet oder zumindest für eine Auswertung vorbereitet, wie beispielsweise digitalisiert.

Beim Vergleich zweier Temperaturen untereinander und Erfassen, ob diese beiden Temperaturen um mehr als eine vorbestimmte Grenze voneinander abweichen, kann auch eine der beiden Temperaturen ein Mittelwert mehrerer Temperaturwerte sein. So kann beispielsweise ein Mittelwert über alle erfassten Temperaturen, also über die Temperaturen jedes der Leitungen, gebildet werden und dann jeweils die einzelnen Temperaturen jeder Leitung jeweils mit diesem Mittelwert verglichen werden. Hierbei kann zwar die Anforderung an die Genauigkeit etwas höher ausfallen, als wenn zwei konkret gemessene Temperaturen miteinander verglichen werden, dafür reicht aber für die Temperatur jeder Leitung ein Vergleich aus, nämlich der Vergleich dieser Temperatur mit der gemittelten Temperatur. So brauchen beispielsweise bei zehn Leitungen nur zehn Vergleiche durchgeführt werden, wenn jeweils die Temperatur jeder Leitung nur mit einer Mittelwerttemperatur verglichen wird. Wird die Temperatur jeder Leitung mit der Temperatur jedes übrigen Leiters untereinander verglichen, was gemäß einer Ausführungsform auch vorgeschlagen wird, so sind in dem genannten Beispiel aber 45 Vergleiche notwendig.

Vorzugsweise kann die Temperatur als eine Art Leistungshebel verwendet werden, die also Aufschluss über die übertragene Leistung gibt. Beispielsweise kann eine Störmeldung ausgegeben werden, wenn eine einzelne Temperaturabweichung auftritt. Diese Temperaturabweichung kann beispielsweise 5°C betragen. Ergänzend wird vorgeschlagen, eine Störmeldung auch bei Überschreiten einer maximalen absoluten Temperatur auszugeben, wenn beispielsweise eine Leitung eine Temperatur von 75°C erreicht.

Die Störmeldung kann in beiden beschriebenen Fällen einen Alarmkontakt schließen, indem ein Alarmschalter geschaltet, insbesondere kurzgeschlossen wird, was entsprechend weiter zur Auswertung genutzt werden kann, beispielsweise kann hierdurch ein weiteres Alarmsignal geschaltet werden, wie beispielsweise eine Warnlampe, ein akustisches Warnsignal und/oder ein Abschalten der Anlage. Außerdem oder alternativ kann die Störmeldung vorsehen, einen Datensatz zu verschicken. Dieser kann Ort und Zeit und ggf. auch weitere Details wie die konkret gemessene Temperatur beinhalten und entsprechend weitergeleitet werden, insbesondere an eine Leitzentrale.

Weiterhin wird eine Überwachungsvorrichtung nach Anspruch 6 vorgeschlagen. Diese Überwachungsvorrichtung ist zum Überwachen eines mehrere elektrische Leitungen umfassenden Leitungsstrangs vorgesehen, wobei der Leitungsstrang zum Leiten elektrisch von einem Generator einer Windenergieanlage erzeugter Energie vorbereitet ist. Die Überwachungsvorrichtung umfasst jeweils einen Temperatursensor an wenigstens zwei der elektrischen Leitungen zum Messen jeweils der Temperatur dieser Leitungen. Weiterhin ist eine Vergleichsvorrichtung zum Vergleich der Temperaturen untereinander vorgesehen und eine Auswertevorrichtung zum Erfassen, ob zwei Temperaturen, also insbesondere die Temperaturen zweier Leitungen, um mehr als eine vorbestimmte Grenze voneinander abweichen. Insbesondere ist eine solche Überwachungsvorrichtung dazu ausgebildet, ein Verfahren gemäß wenigstens einer der oben beschriebenen Ausführungsformen durchzuführen.

Die Überwachungsvorrichtung wird vorteilhafterweise durch einen Prozessrechner zum Verarbeiten der gemessenen Temperaturen weitergebildet, wobei insbesondere der Prozessrechner die Vergleichsvorrichtung und/oder die Auswertevorrichtung bildet. Somit wird insbesondere das Verfahren zum Überwachen ganz oder teilweise auf dem Prozessrechner ausgeführt.

Vorzugsweise ist an jeder der elektrischen Leitungen ein Temperatursensor angeordnet, um die Temperatur jeder dieser elektrischen Leitungen zu erfassen und die beschriebenen Vergleiche durchzuführen. Günstig ist es, als Temperatursensor einen temperaturabhängigen Messwiderstand zu verwenden. Dadurch kann auf einfache Art und Weise die Temperatur gemessen und elektrisch weiterverarbeitet werden. Ebenso ist es auf einfache Art und Weise möglich, an jeder Leitung einen solchen Sensor vorzusehen. So kann selbst bei vielen in dem Strang zusammengefassten elektrischen Leitungen eine vorgeschlagene Überwachung für jede einzelne Leitung vorgenommen werden. Dazu braucht es im einfachsten Fall nur jeweils eines Temperatursensors an jeder der zu überwachenden elektrischen Leitungen und einer Auswerteeinheit, in der sämtliche Temperaturmesswerte zusammenlaufen und ausgewertet werden. Vorzugsweise ist eine Auswerteeinheit bzw. Vorauswerteeinheit zwischen Sensor und Prozessrechner zwischengeschaltet, um ein analoges Messsignal in ein digitales umzuwandeln und/oder um ein Messsignal zu verstärken.

Sofern jede Leitung des Strangs überwacht wird, so betrifft dies die elektrisch parallel geschalteten Leitungen, die die Energie vom elektrischen Generator der Windenergieanlage leiten und dabei einen entsprechenden Strom untereinander aufteilen. Ein Strang bezeichnet insoweit mehrere zusammengefasste Energieleitungen zum Leiten dieser erzeugten elektrischen Energie, unabhängig davon, ob weitere Leitungen zu einem anderen Zweck mit diesem Strang mechanisch verbunden sind, wie beispielsweise Datenleitungen, Schutzleitungen oder Erdungsleitungen, die dabei von der Überwachung ausgenommen sind.

Vorzugsweise sind diese Leitungen des Strangs, und damit der Strang insgesamt, zum Führen eines Gleichstroms vorgesehen.

Die Parallelschaltung der elektrischen Leitung des Strangs bedeutet, dass diese Leitungen an wenigstens einer Verbindungsstelle elektrisch leitend, also galvanisch verbunden sind. Dies kann insbesondere an einer gemeinsamen Klemme oder gemeinsamen Schiene erfolgen. Der zu leitende Strom, der sich auf diese einzelnen Leitungen aufteilen soll, kann beispielsweise insgesamt dieser Schiene oder Klemme zugeführt werden und teilt sich von dort möglichst gleichmäßig auf die einzelnen elektrischen Leitungen auf. Insbesondere eine gute und gleichmäßige elektrische Verbindung jedes dieser elektrischen Leitungen mit der Schiene ist aber wichtig für eine gleichmäßige Aufteilung des Stroms.

Außerdem wird eine Windenergieanlage mit einem Turm mit einem Turmkopf und einem Turmfuß und einem auf dem Turmkopf angeordneten Generator zum Erzeugen elektrischer Energie aus Wind vorgeschlagen. Der Generator ist vorzugsweise in einer auf dem Turmkopf angeordneten Gondel vorgesehen. Weiterhin umfasst die Windenergieanlage einen mehrere elektrische Leitungen umfassenden Leitungsstrang zum Leiten der vom Generator erzeugten elektrischen Energie, insbesondere als Gleichstrom vom Turmkopf zum Turmfuß. Außerdem ist eine Überwachungsvorrichtung vorgesehen, wie sie oben im Zusammenhang mit wenigstens einer Ausführungsform in einer Überwachungsvorrichtung beschrieben wurde. Vorzugsweise führt die Windenergieanlage zur Überwachung der mehreren elektrischen Leitungen des Leitungsstrangs eine Überwachung durch, wie sie oben im Zusammenhang mit den Ausführungsformen des Verfahrens zum Überwachen beschrieben wurde.

Vorzugsweise ist der Leitungsstrang im Turm verlegt und führt die gesamte vom Generator erzeugte Energie, also jeweils die gesamte erzeugte Leistung, durch den Leitungsstrang den Turm hinab. Hierbei werden etwaige Verluste vernachlässigt. Vorzugsweise wird die vom Generator erzeugte Leistung zunächst in einen Gleichstrom umgewandelt, um dann diesen Gleichstrom durch diesen Leitungsstrang zu führen.

Vorzugsweise sind die Leitungen des Leitungsstrangs zueinander parallel geschaltet und dazu vorbereitet, jeweils einen gleich großen Strom zu führen. Insbesondere weisen die elektrischen Leitungen hierzu denselben Querschnitt auf.

Nachfolgend wird die Erfindung anhand eines Ausführungsbeispiels unter Bezugnahme auf die begleitenden Figuren näher beschrieben.
- Fig.1: zeigt eine im Windpark einzusetzende Windenergieanlage schematisch in einer perspektivischen Ansicht.
- Fig. 2: zeigt schematisch eine Anschlussschiene mit mehreren elektrischen Leitungen eines Leitungsstrangs.

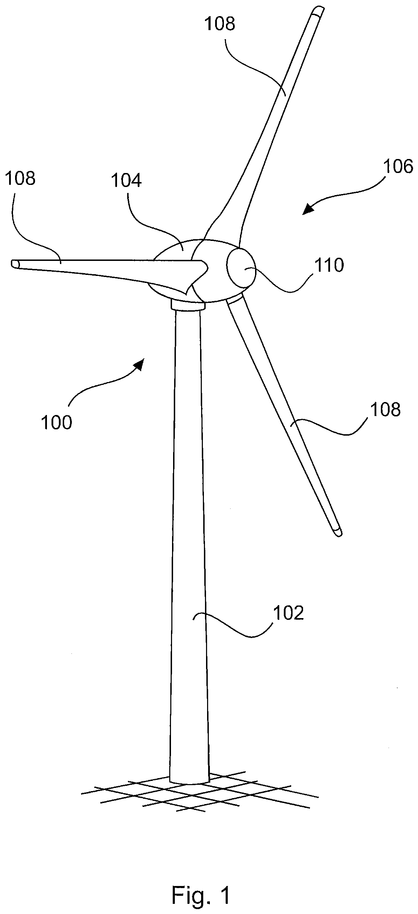

Fig. 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

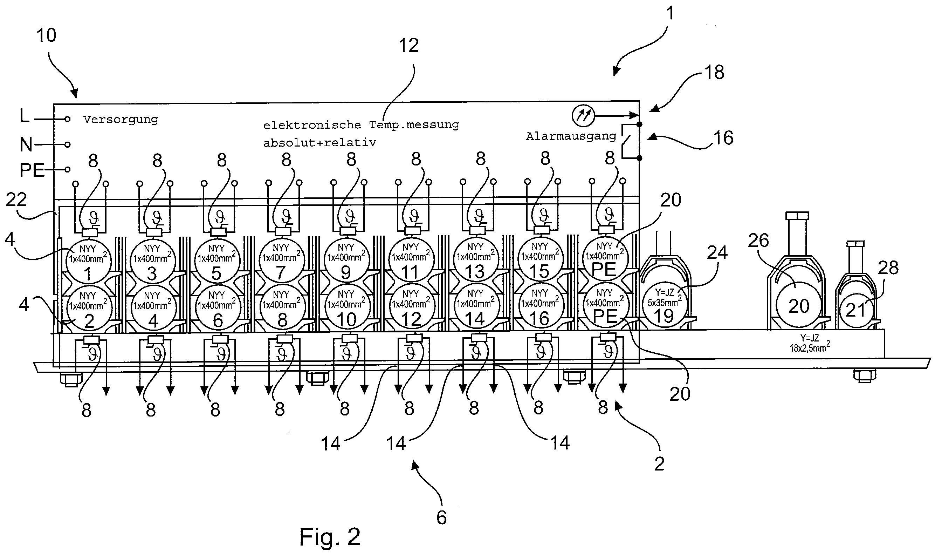

Fig. 2 zeigt eine Überwachungsvorrichtung 1 zum Überwachen eines Kabelstrangs 2, der auch als Leitungsstrang 2 bezeichnet werden kann. Der Leitungsstrang 2 umfasst 16 elektrische Leitungen 4, die hier im Querschnitt dargestellt sind. Sämtliche elektrische Leitungen 4 weisen denselben Querschnitt und überhaupt denselben Typ und dieselbe Ausführung auf. Der gezeigte Typ ist nämlich bekannt unter der Bezeichnung NYY1x400 mm². Durch diese 16 elektrischen Leitungen 4 des Leitungsstrangs 2 soll ein Gleichstrom geführt werden, der die gesamte elektrische Leistung eines Generators einer Windenergieanlage führt.

Die elektrischen Leitungen 4 des Leitungsstrangs 2 sind in Fig. 2 auf einer Klemmvorrichtung 6 zusammengefasst dargestellt. Jedem der elektrischen Leitungen 4 ist dabei ein Temperatursensor 8 zugeordnet, der hier als temperaturveränderlicher Widerstand ausgeführt ist. Die mit den Temperatursensoren 8 gemessenen Temperaturen werden in der Überwachungsvorrichtung 1 ausgewertet. Die Überwachungsvorrichtung 1 ist hierbei unmittelbar neben der Klemmvorrichtung 6 angeordnet, was bei der Umsetzung bauliche Vorteile haben kann. Der Ort der Überwachungsvorrichtung 1 muss aber nicht mit einer solchen Klemmrichtung korrespondieren, sondern kann auch an einer anderen Stelle entlang des Leitungsstrangs 2 vorgenommen werden. Die Verwendung einer Klemmvorrichtung 6 vereinfacht aber auch die Anordnung der Temperatursensoren 8 und erhöht dabei die Verlässlichkeit der Anordnung der Temperatursensoren 8.

Die Überwachungsvorrichtung 1 umfasst einen Versorgungseingang 10, der der Art nach einer normalen elektrischen Stromversorgung entsprechen kann. Hierdurch kann die Überwachungsvorrichtung 1, insbesondere ein darin vorgesehener Prozessrechner mit elektrischer Energie als Versorgungsenergie, versorgt werden. Der Versorgungseingang 10 ist somit Teil eines Auswerteblocks 12, der auch als Auswerteeinheit bezeichnet werden kann, der hier nur schematisch angedeutet ist. In dem Auswerteblock 12 werden die Signale der Temperatursensoren 8 ausgewertet, nämlich aller gezeigten 16 Temperatursensoren 8. Acht der 16 Temperatursensoren 8 weisen gemäß der Darstellung der Fig. 2 nach unten und sind an den Anschlussbeinen des Temperatursensors 8 mit Anschlussleitungen 14 versehen, die symbolisch als Pfeile dargestellt sind, um anzuzeigen, dass diese auch in dem Auswerteblock 12 ausgewertet werden.

Alternativ kann die Energieversorgung des Auswerteblocks 12 auch über die Datenleitung erfolgen, wobei die Schnittstelle mit einer oder mehreren Datenleitungen auskommt, die sowohl als Stromversorgung als auch als Sende- und Empfangsleitung genutzt wird.

Der Auswerteblock 12 vergleicht dann die Temperaturen, die jeweils durch einen Temperatursensor 8 aufgenommen wurden, untereinander und gibt eine Störmeldung aus, sobald zwei Temperaturen um mehr als einen vorbestimmten Wert, insbesondere um mehr als eine vorbestimmte Differenztemperaturgrenze, voneinander abweichen. Die Störungsmeldung kann beispielsweise derart erfolgen, dass an dem Alarmausgang 16 ein Schalter geschlossen oder geöffnet wird. An diesen Alarmausgang 16 kann somit eine elektrische Schaltung oder elektrische Auswerteschaltung angeschlossen werden, um ein solches Schaltsignal von extern auszuwerten oder um durch ein Schalten des Alarmausgangs 16 unmittelbar ein weiteres Alarmsignal oder eine anders geartete Warnmeldung zu erzeugen. Das Schalten kann auch unmittelbar eine Aktion in der Windenergieanlage auslösen, ggf. sogar die Windenergieanlage abschalten.

Außerdem oder alternativ kann über den Alarmdatenausgang 18 ein Datensatz ausgegeben werden, der Art und Umfang der gemessenen Störung enthält. Ein solcher Datensatz kann insbesondere Zeit und Ort der Überwachungsvorrichtung oder Ort der betreffenden Windenergieanlage enthalten. Weiterhin können auch konkret die aufgenommenen Temperaturwerte in einem solchen Datensatz enthalten sein. Dazu sind entweder die Temperaturwerte aller elektrischen Leitungen 4 enthalten oder nur die Temperatur der Leitung, die zu einer störmeldungsauslösenden Abweichung geführt hat.

Neben der Überwachung von Temperaturdifferenzen, also neben dem Vergleich der Temperaturen der elektrischen Leitungen 4 untereinander, übernimmt die Überwachungsvorrichtung 1 auch eine Überwachung der absoluten Temperaturen.

In der Klemmvorrichtung 6 sind zudem zwei Erdleitungen 20 vorhanden, die üblicherweise als PE-Leitungen bezeichnet werden, die aber bestimmungsgemäß keinen Strom führen sollen und entsprechend auch keinen Temperatursensor aufweisen. Die 16 elektrischen Leitungen 4 sind zusammen mit diesen zwei PE-Leitungen 20 in einem Gehäuse 22 zusammengefasst. Außerhalb des Gehäuses 22 ist zudem eine Sicherheitsleitung 24 vorgesehen sowie eine weitere Hilfsleitung 26 und ein Lichtwellenleiter 28, die von der Windenergieanlage gebraucht werden können, für die Überwachungsvorrichtung 1 und das damit durchgeführte Überwachungsverfahren aber nicht von Bedeutung sind.

Somit wird zum Schutz der Turmverkabelung vor Überlastung, insbesondere bei mehrfach parallel verlegten elektrischen Leitungen, eine Überwachung vorgeschlagen. Diese basiert auf unterschiedlichen Temperaturen der Einzelleiter, also der einzelnen elektrischen Leitungen, aufgrund unterschiedlicher Ströme, die bedingt sein können durch hohe Übergangswiderstände, Unterbrechungen, Kurzschlüsse oder andere Vorkommnisse.

Durch die vorgeschlagene Überwachung soll ein Schutz jeder einzelnen elektrischen Leitung der Turmverkabelung vor Überlastung erreicht werden.

Hintergrund ist, dass sich jeder stromdurchflossene Leiter proportional erwärmt, nämlich in Abhängigkeit der Höhe des Stroms. Elektrische Leitungen und Kabel im Allgemeinen sind bis zu einer maximalen Betriebstemperatur spezifiziert. Zum Beispiel ist das Kabel mit der Typbezeichnung NYY bis +70°C Oberflächentemperatur ausgelegt. Durch die Parallelschaltung von zwei oder mehr Leitungen teilt sich der Strom im Idealfall gleichmäßig auf alle Leitungen auf. Somit ist die Erwärmung bei Verwendung von Leitungen gleichen Typs sowie gleicher Länge und Ausführung identisch. Störungen oder technische Mängel bedingt durch fehlerhafte Herstellung, Konfektionierung, Verlegung oder Betrieb der Leitung können zu erhöhten Leitungswiderständen führen, die im reziproken Verhältnis zum Stromfluss stehen. Der verminderte Stromfluss in einer betroffenen Leitung führt zur Stromerhöhung in den anderen parallel verlegten Leitungen und somit dort zu einer Temperaturerhöhung. Die Temperaturdifferenz wird messtechnisch ermittelt, ausgewertet und als Fehler erkannt. Eine absolute Temperaturmessung jeder einzelnen Leitung bewirkt, dass bei Erreichen der maximalen zulässigen Oberflächentemperatur, die beispielsweise für eine Leitung vom Typ NYY 70°C betragen kann, die Windenergieanlage leistungsreduziert oder ggf. gestoppt wird.

Die vorgeschlagene Überwachung bzw. Überwachungsvorrichtung, was insgesamt auch als Mess- und Überwachungssystem bezeichnet werden kann, zeichnet sich auch durch eine hohe Flexibilität in der Anwendung aus. Das vorgeschlagene System arbeitet im Wesentlichen unabhängig vom Kabeltyp und der Anzahl der Leitungen. Die Überwachungsvorrichtung bzw. das entsprechende Verfahren braucht nicht zwingend im Turm angewendet zu werden, sondern kann auch an anderen Stellen, an denen der Strang der elektrischen Leitung verläuft, angewendet werden, wie beispielsweise in der Gondel oder in einem Zusatzgebäude für elektrische Einrichtungen. Das ist dadurch begründet, dass der Stromfluss in den elektrischen Leitungen über die gesamte Länge jeder Leitung identisch ist.

## Patentansprüche

1. Verfahren zum Überwachen eines mehrere elektrische Leitungen (4) umfassenden Leitungsstrangs (2), wobei
der Leitungsstrang (2) zum Leiten elektrischer, von einem Generator einer Windenergieanlage (100) erzeugter Energie vorbereitet ist,
**dadurch gekennzeichnet, dass**
die Leitungen (4) des Leitungsstrangs (2) parallel geschaltet sind; umfassend die Schritte:
- Messen der Temperatur wenigstens zwei der elektrischen Leitungen (4),
- Vergleichen der Temperaturen untereinander und
- Erfassen, ob zwei Temperaturen um mehr als eine vorbestimmte Grenze voneinander abweichen.

2. Verfahren nach Anspruch 1,
**dadurch gekennzeichnet, dass**
eine Störmeldung ausgegeben wird, wenn erfasst wurde, dass zwei Temperaturen um mehr als die vorbestimmte Grenze voneinander abweichen.

3. Verfahren nach Anspruch 1 oder 2,
**dadurch gekennzeichnet, dass**
der Leitungsstrang (2) im Turm (102) der Windenergieanlage (100) verlegt ist und die gesamte vom Generator erzeugte Energie - abzüglich Verluste - den Turm (102) hinab führt.

4. Verfahren nach einem der vorstehenden Ansprüche,
**dadurch gekennzeichnet, dass**
die Leitungen (4) des Leitungsstranges (2) zu einander parallel geschaltet sind und dazu vorbereitet sind, jeweils einen gleich großen Strom zu führen.

5. Verfahren nach einem der vorstehenden Ansprüche,
**dadurch gekennzeichnet, dass**
die Temperatur aller zu überwachender Leitungen (4) in Längsrichtung des Strangs (2) an derselben Stelle gemessen wird, insbesondere an einer Anschluss- oder Messstelle im Turmkopf oder im Turmfuß der Windenergieanlage (100).

6. Überwachungsvorrichtung (1) zum Überwachen eines mehrere elektrische Leitungen (4) umfassenden Leitungsstrangs (2), wobei
der Leitungsstrang (2) zum Leiten elektrischer, von einem Generator einer Windenergieanlage (100) erzeugter Energie vorbereitet ist,
**dadurch gekennzeichnet, dass**
die Leitungen (4) des Leitungsstrangs (2) parallel geschaltet sind; umfassend:
- jeweils einen Temperatursensor (8) an wenigstens zwei der elektrischen Leitungen (4) zum Messen jeweils der Temperatur dieser Leitungen (4),
- eine Vergleichsvorrichtung zum Vergleichen der Temperaturen untereinander und
- eine Auswertevorrichtung (12) zum Erfassen, ob zwei Temperaturen um mehr als eine vorbestimmte Grenze voneinander abweichen.

7. Überwachungsvorrichtung (1) nach Anspruch 6,
**gekennzeichnet, durch**
einen Prozessrechner zum Verarbeiten der gemessenen Temperaturen, wobei insbesondere der Prozessrechner die Vergleichsvorrichtung und/oder die Auswertevorrichtung (12) bildet.

8. Überwachungsvorrichtung (1) nach einem der Ansprüche 6 oder 7,
**dadurch gekennzeichnet, dass**
an jeder der elektrischen Leitungen (4) ein Temperatursensor (8) angeordnet ist und/oder jeder Temperatursensor (8) als temperaturabhängiger Messwiderstand (8) vorgesehen ist.

9. Windenergieanlage (100) mit einem Turm (102) mit einem Turmkopf und einem Turmfuß und einem auf dem Turmkopf angeordneten Generator zum Erzeugen elektrischer Energie aus Wind, einen mehrere elektrische Leitungen (4) umfassenden Leitungsstrang (2) zum Leiten der vom Generator erzeugten elektrischen Energie, insbesondere als Gleichstrom, vom Turmkopf zum Turmfuß und mit einer Überwachungsvorrichtung (1) nach einem der Ansprüche 6 bis 8 zum Überwachen des Leitungsstrangs (2).

10. Windenergieanlage (100) nach Anspruch 9,
**dadurch gekennzeichnet, dass**
der Leitungsstrang (2) im Turm (102) verlegt ist und die gesamte vom Generator erzeugte Energie - abzüglich Verluste - durch den Leitungsstrang (2) den Turm hinab geführt wird.

11. Windenergieanlage (100) nach Anspruch 9 oder 10,
**dadurch gekennzeichnet, dass**
die Leitungen (4) des Leitungsstranges (2) zu einander parallel geschaltet sind und dazu vorbereitet sind, jeweils einen gleich großen Strom zu führen, insbesondere dass die Leitungen (4) jeweils denselben Querschnitt aufweisen.

## Claims

1. Method for monitoring multiple electrical energy lines (4) in a cable harness (2) such that
the cable harness (2) is set up to conduct electrical energy generated by a generator in a wind turbine (100),
**characterized in that**
the lines (4) in the cable harness (2) are connected in parallel; involving the following steps:
- Measuring the temperature of at least two of the electrical lines (4),
- Comparing the temperatures of said lines, and
- Determining whether the two temperatures deviate from one another by more than a predetermined limit.

2. Method according to Claim 1,
**characterized in that**
a malfunction message will be emitted if it is determined that two temperatures deviate from one another by more than the predetermined threshold.

3. Method according to Claim 1 or 2,
**characterized in that**
the cable harness (2) is laid inside the tower (102) of the wind turbine (100) and that all of the energy generated by the generator - less any losses - is transmitted down from the tower (102).

4. Method according to one of the above claims,
**characterized in that**
the lines (4) in the cable harness (2) are connected in parallel to one another and therefore each one is capable of carrying an equally high current.

5. Method according to one of the above claims,
**characterized in that**
the temperature of all lines (4) being monitored will be measured in a longitudinal direction of the harness (2) and at the same point, specifically therefore at a connection or measuring point in the top of the tower or at a connection or measuring point in the tower base of the wind turbine (100).

6. Monitoring device (1) for monitoring a cable harness (2) containing multiple electrical energy lines (4) such that
the cable harness (2) is set up to conduct electrical energy generated by a generator in a wind turbine (100),
**characterized in that**
the lines (4) in the cable harness (2) are connected in parallel; involving:
- a temperature sensor (8) on at least two of the electrical lines (4) to measure the respective temperatures of these lines (4),
- a comparison device to compare the temperatures of said lines, and
- an evaluation device (12) to determine whether the two temperatures deviate from one another by more than a predetermined limit.

7. Monitoring device (1) according to Claim 6,
**characterized by**
a process computer for processing the temperatures measured, such that in particular the process computer may be the comparison device and/or the evaluation device (12).

8. Monitoring device (1) according to one of Claims 6 or 7,
**characterized in that**
on each of the electrical lines (4) there is a temperature sensor (8) and/or each temperature sensor (8) is designed as a temperature-dependent precision resistor (8).

9. Wind turbines (100) with a tower (102) and a top and a tower base, and a generator installed in the top of the tower for generating electrical energy from wind, a cable harness (2) containing multiple electrical lines (4) to conduct the electrical energy generated by the generator, specifically as direct current, from the top of the tower to the tower base, and which has a monitoring device (1) according to one of Claims 6 to 8 for monitoring the cable harness (2).

10. Wind turbine (100) according to Claim 9,
**characterized in that**
the cable harness (2) is laid inside the tower (102) and that all of the energy generated by the generator - less any losses - is transmitted down from the tower (102).

11. Wind turbine (100) according to Claim 9 or 10,
**characterized in that**
the lines (4) in the cable harness (2) are connected in parallel to one another and therefore each one is capable of carrying an equally high current, specifically that each one has the same cross-section.

## Revendications

1. Procédé pour surveiller un faisceau de câbles (2) comprenant plusieurs câbles électriques (4), dans lequel
le faisceau de câbles (2) est préparé pour conduire de l'énergie électrique produite par un générateur d'une éolienne (100),
**caractérisé en ce que**
les câbles (4) du faisceau de câbles (2) sont montés en parallèle ; comprenant les étapes consistant à :
- mesurer la température d'au moins deux des câbles électriques (4),
- comparer les températures entre elles et
- relever si deux températures diffèrent l'une de l'autre de plus d'un seuil prédéfini.

2. Procédé selon la revendication 1,
**caractérisé en ce que**
un message d'erreur est émis lorsqu'il est relevé que deux températures diffèrent l'une de l'autre de plus du seuil prédéfini.

3. Procédé selon la revendication 1 ou 2,
**caractérisé en ce que**
le faisceau de câbles (2) est posé dans la tour (102) de l'éolienne (100) et transporte la totalité de l'énergie produite par le générateur - moins les pertes - en bas de la tour (102).

4. Procédé selon l'une des revendications précédentes,
**caractérisé en ce que**
les câbles (4) du faisceau de câbles (2) sont montés parallèles les uns aux autres et préparés pour conduire respectivement un courant de même grandeur.

5. Procédé selon l'une des revendications précédentes,
**caractérisé en ce que**
la température de tous les câbles à surveiller (4) dans la direction longitudinale du faisceau (2) est mesurée au même endroit, en particulier au niveau d'un point de branchement ou de mesure dans la tête de la tour ou dans la base de la tour de l'éolienne (100).

6. Dispositif de surveillance (1) pour surveiller un faisceau de câbles (2) comprenant plusieurs câbles électriques (4), dans lequel
le faisceau de câbles (2) est préparé pour conduire de l'énergie électrique produite par un générateur d'une éolienne (100),
**caractérisé en ce que**
les câbles (4) du faisceau de câbles (2) sont montés en parallèle ; comprenant :
- respectivement un capteur de température (8) sur au moins deux des câbles électriques (4) pour mesurer respectivement la température de ces câbles (4),
- un dispositif de comparaison pour comparer les températures entre elles et
- un dispositif d'évaluation (12) pour relever si deux températures diffèrent l'une de l'autre de plus d'un seuil prédéfini.

7. Dispositif de surveillance (1) selon la revendication 6,
**caractérisé par**
un processeur pour traiter les températures mesurées, dans lequel le processeur en particulier forme le dispositif de comparaison et/ou le dispositif d'évaluation (12).

8. Dispositif de surveillance (1) selon l'une des revendications 6 ou 7,
**caractérisé en ce que**
un capteur de température (8) est disposé au niveau de chacun des câbles électriques (4) et/ou chaque capteur de température (8) est prévu comme résistance de mesure dépendant de la température (8).

9. Eolienne (100) avec une tour (102) avec une tête de tour et une base de tour et un générateur disposé sur la tête de tour pour produire de l'énergie électrique à partir du vent, un faisceau de câbles (2) comprenant plusieurs câbles électriques (4) pour conduire l'énergie électrique produite par le générateur, en particulier sous forme de courant continu, de la tête de la tour à la base de la tour et avec un dispositif de surveillance (1) selon l'une des revendications 6 à 8 pour surveiller le faisceau de câbles (2).

10. Eolienne (100) selon la revendication 9,
**caractérisée en ce que**
le faisceau de câbles (2) est posé dans la tour (102) et la totalité de l'énergie produite par le générateur - moins les pertes - est transportée en bas de la tour via le faisceau de câbles (2).

11. Eolienne (100) selon la revendication 9 ou 10,
**caractérisée en ce que**
les câbles (4) du faisceau de câbles (2) sont montés parallèles les uns aux autres et préparés pour conduire respectivement un courant de même grandeur, en particulier **en ce que** les câbles (4) présentent respectivement la même section.
